(19) Europäisches Patentamt
European Patent Office
Office européen des brevets

(11) **EP 4 318 006 B1**

(12) **EUROPEAN PATENT SPECIFICATION**

(45) Date of publication and mention
of the grant of the patent:
**26.11.2025 Bulletin 2025/48**

(21) Application number: **22890292.0**

(22) Date of filing: **28.10.2022**

(51) International Patent Classification (IPC):
*G01R 31/3835* (2019.01)  *G01R 27/02* (2006.01)
*G01R 31/327* (2006.01)  *G01R 31/396* (2019.01)
*G01R 15/04* (2006.01)  *G01R 31/36* (2020.01)

(52) Cooperative Patent Classification (CPC):
**G01R 15/04; G01R 31/36**

(86) International application number:
**PCT/KR2022/016677**

(87) International publication number:
**WO 2023/080559 (11.05.2023 Gazette 2023/19)**

(54) **BATTERY PACK VOLTAGE MEASUREMENT CIRCUIT AND OPERATION METHOD THEREOF**

BATTERIEPACKSPANNUNGSMESSSCHALTUNG UND BETRIEBSVERFAHREN DAFÜR

CIRCUIT DE MESURE DE TENSION DE BLOC-BATTERIE ET SON PROCÉDÉ DE
FONCTIONNEMENT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **02.11.2021 KR 20210148907**

(43) Date of publication of application:
**07.02.2024 Bulletin 2024/06**

(73) Proprietor: **LG Energy Solution, Ltd.
Seoul 07335 (KR)**

(72) Inventor: **KIM, Kang San
Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:
CN-U- 204 216 780       JP-A- 2012 018 037
KR-A- 20130 068 986     KR-A- 20170 014 962
KR-A- 20180 043 030     KR-A- 20210 104 458
US-A1- 2019 064 285

**Description**

## TECHNICAL FIELD

The present invention relates to a battery pack voltage measurement circuit and a method for operating the same, and more particularly, to a battery pack voltage measurement circuit for measuring a voltage of a battery pack and outputting a result value thereof, and a method for operating the same.

## BACKGROUND ART

Recently, as the demand for electric and electronic devices is rapidly increasing, interest in battery packs is also increasing. Since the battery pack used as a storage battery or a secondary battery is an essential component for driving the electric and electronic devices, the battery pack is continuously developing along with the electric and electronic devices.

Meanwhile, as the issue of eco-friendly technology is amplified around the world, products related to electric vehicles and solar module are being mass-produced explosively. Since electric vehicles and solar modules are also basically configured with the battery pack, the demand for the battery pack is increasing. The battery pack is being developed to be used longer and driven more powerfully according to consumer demand. That is, the battery pack is developing into a battery pack with a high-capacity and high-voltage specifications.

The high-voltage specifications for the battery pack provides more powerful driving power to a peripheral circuitry that uses the battery pack in an ideal situation, but causes serious damage to the peripheral circuitry in a situation where unwanted problems arise. Therefore, measuring and managing a voltage of the battery pack in order to prevent an abnormal current from occurring in the battery pack can be regarded as an essential item in the battery pack. Therefore, the battery pack is configured together with the battery pack voltage measurement circuit for this purpose.

The battery pack voltage measurement circuit includes a relay switch and an analog to digital converting (ADC) output circuit. The relay switch of the battery pack voltage measurement circuit can perform an on or off operation based on an overcurrent, and the ADC output circuit can measure a voltage of the battery pack according to a current flowing through the relay switch.

Meanwhile, the voltage of battery pack used in the electric vehicles is increasing from 400 V to 800 V. Accordingly, the battery pack voltage measurement circuit should also be designed to match an increased voltage of the battery pack. To this end, the relay switch configured in the battery pack voltage measurement circuit should satisfy an allowable voltage value of 800 V. However, in the case of a relay switch that operates stably at the allowable voltage value of 800 V, a switch having very high price, i.e., a relay switch with high specifications is required because advanced process technology is required and high-quality materials should be used. If a relay switch with low specifications having an allowable voltage value of 400 V is used to measure a voltage of the battery pack of 800 V, the OFF time of the relay switch may be delayed, and thus various problems due to this delay may be caused.

In this regard, Japanese patent registration No. 4385640 (registration date: 2009.10.09.) and Korean patent registration No. 1211055 (registration date: 2012.12.05.) disclose a configuration for detecting the voltage of the battery pack. The two patent documents disclose a relay switch that is directly connected to the voltage of the battery pack. In this case, as described above, if a relay switch with high specifications is not used, a smooth measurement operation for the high voltage battery pack is impossible.

Related art includes the following prior art.

Patent literature 1: JP 4385640 B2(2009.10.09.)
Patent literature 2: KR 1211055 B1(2012.12.05.)

US 2019 / 064285 A1 describes a relay diagnosis circuit, a diagnosis method and a battery management system. The relay diagnosis circuit may include a first sampling unit, a second sampling unit, a first sampling point, a second sampling point, a reference voltage terminal and a processor. A first end of the first sampling unit is connected with voltage output end of the power battery pack to be measured and a first end of a relay. A second end of the first sampling unit is connected with the reference voltage terminal and the first sampling point. A first end of the second sampling unit is connected with a second end of the relay. A second end of the second sampling unit is connected with the reference voltage terminal and the second sampling point.

## DISCLOSURE OF THE INVENTION

## TECHNICAL PROBLEM

Therefore, the present invention is intended to to provide a battery pack voltage measurement circuit capable of stably operating a relay element of low specifications even when a voltage of a battery pack is high, and a method for operating the same.

## TECHNICAL SOLUTION

The present invention is defined according to the subject matter of the appended independent claims. Particular embodiments are given by the additional features of the appended dependent claims. In order to achieve the object described above, according to an aspect of the present invention, there is provided a battery pack voltage measurement circuit including a first resistor, the relay circuit, a second resistor, and an ADC output circuit, the first resistor, a relay circuit, the second resistor, and the ADC output circuit being sequentially connected in series between a power supply voltage terminal to which a voltage of a battery pack is applied and a ground voltage terminal, in which the relay circuit is configured by connecting a relay element and a relay resistor in parallel.

Further, when the relay element is turned OFF, a voltage applied to both ends of the relay element is the same as a voltage applied to both ends of the relay resistor.

Further, a resistance value $R_r$ of the relay resistor may be determined to satisfy the following [Equation 1].

In addition, a resistance value $R_r$ of the relay resistor may be determined to satisfy the following [Equation 2].

In order to achieve the object described above, according to another aspect of the present invention, there is provided a method for operating a battery pack voltage measurement circuit, the method including a process of dropping a battery pack voltage applied to measure the battery pack voltage, a process of determining an ON state of a relay element according to the battery pack voltage, a process of setting a voltage across the relay element to be the same as a voltage across the relay resistor based on the result of the process of determining, and a process of detecting the battery pack voltage.

In order to achieve the object described above, according to still another aspect of the present invention, there is provided a battery pack voltage measurement circuit including a voltage drop circuit, a relay circuit, and an ADC output circuit, the voltage drop circuit, the relay circuit, and the ADC output circuit being sequentially connected in series between a power supply voltage terminal to which a voltage of a battery pack is applied and a ground voltage terminal, in which the relay circuit is configured by connecting a relay element and a relay resistor in parallel.

Further, the voltage drop circuit may include a resistor connected between the power supply voltage terminal and the relay circuit and for dropping a voltage applied to the power supply voltage terminal.

Further, battery pack voltage measurement circuit may include a resistor connected between the relay circuit and the ADC output circuit and for dropping and dividing a voltage applied to the relay circuit.

## ADVANTAGEOUS EFFECTS

As described above, according to the present invention, it is possible to use a relay element of low specifications having a low allowable voltage value by dropping the voltage of the battery pack applied to the relay circuit.

That is, the present invention includes the first resistor, the relay circuit, the second resistor, and the ADC output circuit that are sequentially connected in series between the power supply voltage terminal to which the voltage of the battery pack is applied and the ground voltage terminal, and the relay circuit detects the voltage of the battery pack by connecting the relay element and the relay resistor in parallel.

In this case, the relay element configured in the relay circuit can be used as a relay element of low specifications through the series connection structure of the first and second resistors and the parallel connection structure of the relay resistors. Therefore, even if the voltage of the battery pack to be detected increases, the manufacturing cost of the battery pack voltage measurement circuit can be reduced by using a relay element of low specifications having a low price instead of a relay element of high specifications having an expensive price.

## BRIEF DESCRIPTION OF THE DRAWINGS

FIG. 1 is a diagram illustrating a battery pack voltage measurement circuit according to an embodiment of the present invention.
FIG. 2 is a flowchart illustrating a method for operating the battery pack voltage measurement circuit of FIG. 1.
FIG. 3 is a diagram illustrating a battery pack voltage measurement circuit according to another embodiment of the present invention.
FIG. 4 is a diagram illustrating a battery pack voltage measurement circuit according to the related art.

## MODE FOR CARRYING OUT THE INVENTION

Hereinafter, embodiments of the present invention will be described in detail with reference to the accompanying drawings. However, the present invention is not limited to the embodiments disclosed below, but will be implemented in various different forms. The embodiments of the present invention are provided only to complete the disclosure of the present invention, and to fully inform those of ordinary skill in the scope of the present invention. In the drawings, the same reference numerals refer to the same elements.

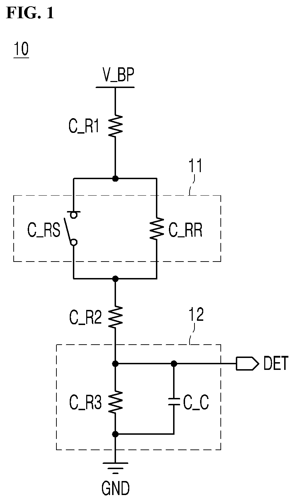

FIG. 1 is a diagram illustrating a battery pack voltage measurement circuit 10 according to an embodiment of the present invention.

Referring to FIG. 1, the battery pack voltage measurement circuit 10 according to an embodiment of the present invention includes a first resistor C_R1, a relay circuit 11, a second resistor C_R2, and an ADC output circuit 12. Here, the first resistor C_R1, the relay circuit 11, the second resistor C_R2, and the ADC output circuit 12 are sequentially connected in series between a power supply voltage terminal V_BP to which a voltage of a battery pack (not illustrated) is applied and a ground voltage terminal GND.

The first resistor C_R1 is connected between the power supply voltage terminal V_BP and the relay circuit 11. The first resistor C_R1 drops the voltage of the battery pack applied from the power voltage terminal V_BP to provide the voltage to the relay circuit 11. Accordingly, even when the voltage of the battery pack of, for example, 800 V is applied to the power supply voltage terminal V_BP, the voltage dropped by the first resistor C_R1 is applied to the relay circuit 11.

The relay circuit 11 includes a relay element C_RS and a relay resistor C_RR. Here, the relay element C_RS and the relay resistor C_RR are configured to be connected in parallel between the first resistor C_R1 and the second resistor C_R2 in seriese.

The relay element (C_RS) is not illustrated in detail in the drawing, but may be configured with a solenoid and a switch. In the relay element C_RS, an on or off operation of a switch may be controlled based on magnetic force generated in the solenoid. The relay resistor C_RR is connected in parallel with the relay. Accordingly, when the relay element C_RS is turned OFF, the voltage applied to both ends of the relay element C_RS is the same as the voltage applied to both ends of the relay resistor C_RR.

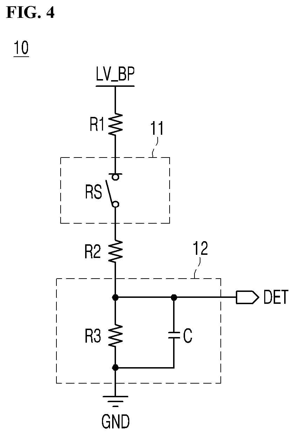

The circuit configuration of the present invention as described above solves the problem that a high-rated relay is required for the case of a system with a high pack voltage, e.g., 800 V because most of LV_BP is applied to both ends of the relay element RS when the relay element RS is turned OFF in the related art as illustrated in FIG. 4. In the present invention, due to the relay resistance C_RR, only a low level pack voltage, which is a part of the pack voltage, is applied even when the relay is turned OFF, and thus, an effect of capable of applying, e.g., a relay rated for a 400 V system to an 800 V system is achieved.

That is, since the voltage dropped by the first resistor C_R1 is applied to one side of the relay element C_RS, the relay element C_RS may be designed as a relay element of low specifications. Also, since the voltage dropped by the first resistor C_R1 and the relay resistor C_RR is applied to the other side of the relay element C_RS, a stable on or off operation can be guaranteed even when the relay element C_RS is used as the relay element of low specifications.

The second resistor C_R2 is connected between the relay circuit 11 and the ADC output circuit 12. The second resistor C_R2 is a configuration for dropping and distributing the voltage applied to the relay circuit 11, and as will be described later by equations, a more stable voltage may be applied to both ends of the relay element C_RS through the second resistor C_R2.

The ADC output circuit 12 includes a third resistor R3 and a capacitor C. Here, the third resistor R3 and the capacitor C are configured to be connected in parallel between the second resistor C_R2 and the ground voltage terminal GND. The ADC output circuit 12 converts an analog voltage transferred through the second resistor C_R2 into a digital voltage to generate a detection signal DET corresponding to the voltage of the battery pack. Since a circuit operation of the ADC output circuit 12 is already known, a detailed description thereof will be omitted.

Meanwhile, a resistance value $R_r$ of the relay resistor C_RR is determined to satisfy [Equation 1] below.

$$\frac{R_r}{(R_1 + R_2 + R_3)} \times V_o < V_{\text{lim}}$$

[Equation 1] is an expression excluding the ADC output circuit 12 for convenience of explanation. Here, $R_1$ and $R_2$ are resistance values of the first and second resistors C_R1 and C_R2, respectively, $V_{\text{lim}}$ is an allowable voltage value of the relay element C_RS, and $V_o$ is a voltage value of the battery pack.

As can be seen from [Equation 1], the allowable voltage value $V_{\text{lim}}$ of the relay element C_RS should be smaller than the voltage value $V_o$ of the battery pack. In this case, a voltage drop of the voltage value $V_o$ of the battery pack is made by the resistance values $R_1$, $R_2$, and $R_r$ of the first and second resistors C_R1 and C_R2 and the relay resistor C_RR, respectively. Therefore, even if the voltage value $V_o$ of the battery pack increases, for example, from 400 V to 800 V, if the resistance values $R_1$, $R_2$, and $R_r$ of the first and second resistors C_R1 and C_R2 and the relay resistor C_RR are appropriately designed, the allowable voltage value $V_{\text{lim}}$ of the relay element C_RS may be satisfied. Here, the fact that the allowable voltage value $V_{\text{lim}}$ of the relay element C_RS is satisfied even when the voltage value $V_o$ becomes 800 V means that the voltage $V_o$ of the battery pack having a high voltage can be measured stably even if a relay element of low specifications is used.

Further, when the relay element (C_RS) is turned OFF, the voltage dropped by the first resistor $R_1$ is applied to one end of the relay element C_RS, and a voltage equal to the voltage applied to both ends of the relay resistor C_RR is applied to both ends of the relay element C_RS. Therefore, even when a relay element of low specifications is used for the relay element C_RS, the off operation of the relay element C_RS can be stably performed.

As described above, through this configuration and operation, the battery pack voltage measurement circuit 10 according to the embodiment of the present invention provides an environment in which a relay element of low specifications can be used for the relay element C_RS.

On the other hand, the resistance value $R_r$ of the relay resistor C_RR is determined to satisfy [Equation 2] below.

$$\frac{R_r}{(R_1 + R_2 + R_c + R_r)} \times V_o < V_{\text{lim}}$$

[Equation 2] is an expression including the ADC output circuit 12. Here, $R_1$ and $R_2$, and $R_c$ are the resistance values of the first and second resistors C_R1 and C_R2, and the resistance values of the ADC output circuit 12, respectively, and $V_{lim}$ is the allowable voltage value of the relay element C_RS, and $V_o$ is the voltage value of the battery pack.

[Equation 2] also like [Equation 1], the allowable voltage value $V_{lim}$ of the relay element C_RS may be smaller than the voltage value $V_o$ of the battery pack, and a voltage drop of the voltage value $V_o$ of the battery pack is made by $R_1$ and $R_2$, $R_c$, and $R_r$, which are the resistance values of the first and second resistors C_R1 and C_R2, the ADC output circuit 12, and the relay resistor C_RR, respectively. In particular, [Equation 2] means that the voltage value $V_o$ of the battery pack can be controlled lower by the resistance value $R_c$ of the ADC output circuit 12. This means that even if the voltage value $V_o$ of the battery pack becomes higher, it can be included in the allowable voltage value $V_{lim}$ of the relay element C_RS.

As described above, since the battery pack voltage measurement circuit 10 according to the embodiment of the present invention can use the relay element C_RS of low specifications, the battery pack voltage measurement circuit 10 can be mass-produced at a lower manufacturing cost.

The embodiment of the present invention will be described with specific values of resistance values and pack voltage applied to the circuit of the present invention of FIG. 1 and the circuit of the related art of FIG. 4.

In the related art of FIG. 4, when a pack voltage LV_BP is 400 V and the relay is turned ON, the pack voltage should be detected by being subjected to ADC at a ratio of 100:1 in order to match an ADC input limit of 5 V, and thus each of $R_1$ and $R_2$ may be set to 1 MΩ and $R_3$ may be set to 20kΩ. In this case, when the relay is turned OFF, an applied resistance value RS of a predetermined relay corresponds to about $10^{14}$ Ω, so that most of the pack voltage is applied to the relay. That is, in order to apply the circuit of the related art of FIG. 4 to a high voltage system in which the pack voltage is 800 V, an expensive relay corresponding to the 800 V system should be used.

On the other hand, in the detection circuit of the present invention in FIG. 1, a pack voltage V_BP is 800 V, and when the relay is turned ON, the pack voltage should be detected by being subjected to ADC at a ratio of 200:1 to match the ADC input limit value of 5 V. Therefore, C_R1 and C_R2 may be set to 6 MΩ, 3 MΩ, and R3 to 45 kΩ, respectively. In this case, unlike the prior art, if the relay resistance C_RR is added in parallel and set to 10 MΩ, when the relay is turned OFF, a pack voltage of 10 M/19.45 M is applied to both ends of the relay, and only about half of the pack voltage is applied. Therefore, it becomes possible to apply a relay having the same level of rating as in a system having a pack voltage of 400 V.

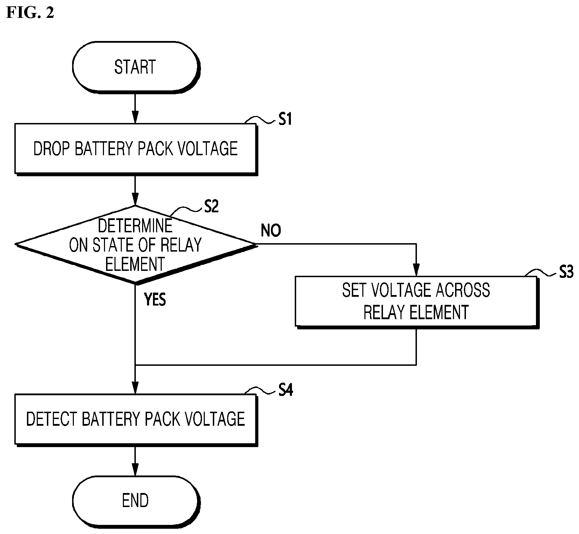

FIG. 2 is a flowchart illustrating a method for operating the battery pack voltage measurement circuit 10 of FIG. 1.

Referring to FIGS. 1 and 2, the method for operating the battery pack voltage measurement circuit 10 includes a process S1 of dropping the battery pack voltage, a process S2 of determining the ON state of the relay element, a process S3 of setting the voltage across the relay element, and a process S4 of detecting the battery pack voltage.

The process of dropping the battery pack voltage S1 is a process of dropping the battery pack voltage applied from the power supply voltage terminal V_BP to measure the voltage of the battery pack. The process S1 of dropping the battery pack voltage may be performed by the first to third resistors C_R1, C_R2, and C_R3 of FIG. 1.

The process S2 of determining the ON state of the relay element is a process of determining the ON state of the relay element C_RS (see FIG. 1) according to the battery pack voltage. If the relay element C_RS is in an OFF state (No), the process S3 to be described later is performed. If the relay element C_RS is in an ON state (Yes), the process S4 to be described later is performed.

The process S3 of setting the voltage across the relay element is a process of setting the voltage across the relay element C_RS to be the same as the voltage across the relay resistor C_RR when the relay element C_RS is in the OFF state (No), based on the result of the determining process S2. The process S3 of setting the voltage across the relay element may be performed by the relay resistor C_RR of FIG. 1.

The process S4 of detecting the battery pack voltage is a process of detecting an analog type battery pack voltage applied from the power supply voltage terminal V_BP and outputting it as a digital type detection signal DET. The process S4 of detecting the battery pack voltage may be performed in the ADC output circuit 12 of FIG. 1.

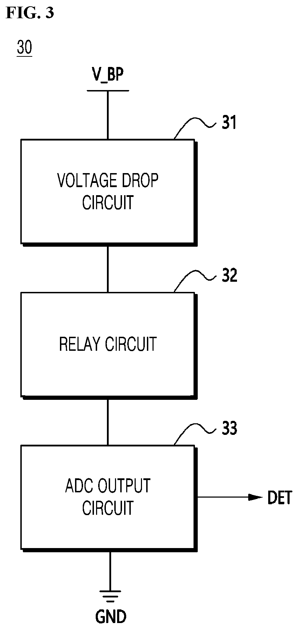

FIG. 3 is a diagram illustrating a battery pack voltage measurement circuit 30 according to another embodiment of the present invention.

Referring to FIG. 3, the battery pack voltage measurement circuit 30 according to another embodiment of the present invention includes a voltage drop circuit 31, a relay circuit 32, and an ADC output circuit 33. Here, the voltage drop circuit 31, the relay circuit 32, and the ADC output circuit 33 are sequentially connected in series between the power supply voltage terminal V_BP to which a voltage of a battery pack (not illustrated) is applied and the ground voltage terminal GND.

The voltage drop circuit 31 is a configuration connected between the power supply voltage terminal V_BP and the relay circuit 22 and for dropping the voltage applied to the power supply voltage terminal V_BP. The voltage drop circuit 31 may correspond to the first resistor C_R1 of FIG. 1. As already described in Figure 1, the voltage drop circuit 31 drops the voltage of the battery pack applied to the power supply voltage terminal V_BP through the first resistor C_R1 to provide it to the relay circuit 32.

The relay circuit 32 is configured with the relay element C_RS and the relay resistor C_RR of FIG. 1. The ADC output circuit 33 is configured with the third resistor C_R3 and the capacitor C_C of FIG. 1. Since the configuration and operation of the relay circuit 32 and the ADC output circuit 33 have been sufficiently described with reference to FIG. 1, a more detailed description thereof will be omitted.

Meanwhile, the battery pack voltage measurement circuit 30 further includes the second resistor C_R2 of FIG. 1 connected between the relay circuit 32 and the ADC output circuit 33. As described in FIG. 1, the second resistor C_R2 is a configuration for dropping and distributing the voltage applied to the relay circuit 32.

As described above, since the battery pack voltage measurement circuit 30 according to the embodiment of the present invention can use the relay element C_RS with low specifications, the battery pack voltage measurement circuit 30 can be mass-produced at a lower manufacturing cost.

## Claims

**1.** A battery pack voltage measurement circuit (10) comprising:

a first resistor (C_R1);
a relay circuit (11);
a second resistor (C_R2); and
an ADC output circuit (12),
wherein the first resistor (C_R1), the relay circuit (11), the second resistor (C_R2), and the ADC output circuit (12) are sequentially connected in series between a power supply voltage terminal (V_BP) to which a voltage of a battery pack is applied and a ground voltage terminal (GND), and
wherein the relay circuit (11) is configured by connecting a relay element (C_RS) and a relay resistor (C_RR) in parallel,
**characterised in that**,
when the relay element (C_RS) is turned OFF, a voltage applied to both ends of the relay element (C_RS) is the same as a voltage applied to both ends of the relay resistor (C_RR).

**2.** The circuit of claim 1, wherein
a resistance value $R_r$ of the relay resistor (C_RR) is determined to satisfy the following [Equation 1],

$$[\text{Equation 1}]$$

$$\frac{R_r}{(R_1 + R_2 + R_3)} \times V_o < V_{\lim}$$

where, $R_1$ and $R_2$ are resistance values of the first and second resistors (C_R1, C_R2), respectively, $V_{\lim}$ is an allowable voltage value of the relay element (C_RS), and $V_o$ is a voltage value of the battery pack.

**3.** The circuit of claim 1, wherein
a resistance value $R_r$ of the relay resistor (C_RR) is determined to satisfy the following [Equation 2],

$$[\text{Equation 2}]$$

$$\frac{R_r}{(R_1 + R_2 + R_c + R_r)} \times V_o < V_{\lim}$$

where $R_1$ and $R_2$, and $R_c$ are resistance values of the first and second resistors (C_R1, C_R2) and a resistance value of the ADC output circuit (12), respectively, $V_{\lim}$ is an allowable voltage value of the relay element (C_RS), and $V_o$ is a voltage value of the battery pack.

**4.** A battery pack voltage measurement circuit (10) comprising:

a voltage drop circuit (31);
a relay circuit (11; 32); and
an ADC output circuit (12; 33),
wherein the voltage drop circuit, the relay circuit (11), and the ADC output circuit (12) are sequentially connected in series between a power supply voltage terminal (V_BP) to which a voltage of a battery pack is applied and a ground voltage terminal (GND), and
wherein the relay circuit (11) is configured by connecting a relay element (C_RS) and a relay resistor (C_RR) in parallel,
**characterised in that**,
when the relay element (C_RS) is turned OFF, a voltage applied to both ends of the relay element (C_RS) is the same as a voltage applied to both ends of the relay resistor (C_RR).

**5.** The circuit of claim 4, wherein
the voltage drop circuit (31) comprises a resistor (C_R1) connected between the power supply voltage terminal (V_BP) and the relay circuit (11; 32) and for dropping a voltage applied to the power supply voltage terminal (V_BP).

**6.** The circuit of claim 4, further comprising:
a resistor (C_R2) connected between the relay circuit (11; 32) and the ADC output circuit (12; 33) and for dropping and dividing a voltage applied to the relay circuit (11; 32).

**7.** A method for operating the battery pack voltage measurement circuit (10) of any one of claims 4 to 6, the method comprising:

a process of applying a voltage of the battery pack for voltage measurement across the battery pack and reducing said voltage through the voltage drop circuit (31);
a process of determining whether the relay element (C_RS) is in an ON state;
a process of setting a voltage across the relay element (C_RS) to be the same as a voltage across the relay resistor (C_RR) if the relay element (C_RS) is not in an ON state; and
a process of detecting the voltage of the battery pack.

## Patentansprüche

1. Batteriepack-Spannungsmessschaltung (10) aufweisend:

einen ersten Widerstand (C_R1);
eine Relaisschaltung (11);
einen zweiten Widerstand (C_R2); und
eine ADC-Ausgangsschaltung (12),
wobei der erste Widerstand (C_R1), die Relaisschaltung (11), der zweite Widerstand (C_R2) und die ADC-Ausgangsschaltung (12) zwischen einem Stromversorgungsspannungsanschluss (V_BP), an den eine Spannung eines Batteriepacks angelegt wird, und einem Massespannungsanschluss (GND) nacheinander in Reihe geschaltet sind, und
wobei die Relaisschaltung (11) durch Parallelschalten eines Relaiselements (C_RS) und eines Relaiswiderstands (C_RR) konfiguriert ist, **dadurch gekennzeichnet, dass**, wenn das Relaiselement (C_RS) ausgeschaltet ist, eine an beide Enden des Relaiselements (C_RS) angelegte Spannung die gleiche ist wie eine an beide Enden des Relaiswiderstands (C_RR) angelegte Spannung.

2. Schaltung nach Anspruch 1, wobei ein Widerstandswert $R_r$ des Relaiswiderstands (C_RR) bestimmt wird, um die folgende [Gleichung 1] zu erfüllen,

[Gleichung 1]

$$\frac{R_r}{(R_1 + R_2 + R_3)} \times V_o < V_{\lim}$$

wobei $R_1$ und $R_2$ Widerstandswerte des ersten bzw. zweiten Widerstands (C_R1, C_R2) sind, $V_{\lim}$ ein zulässiger Spannungswert des Relaiselements (C_RS) ist und $V_o$ ein Spannungswert des Batteriepacks ist.

3. Schaltung nach Anspruch 1, wobei ein Widerstandswert $R_r$ des Relaiswiderstands (C_RR) bestimmt wird, um die folgende [Gleichung 2] zu erfüllen,

[Gleichung 2]

$$\frac{R_r}{(R_1 + R_2 + R_c + R_r)} \times V_o < V_{\lim}$$

wobei $R_1$ und $R_2$ und $R_c$ Widerstandswerte des ersten bzw. zweiten Widerstands (C_R1, C_R2) und ein Widerstandswert der ADC-Ausgangsschaltung (12) sind, $V_{\lim}$ ein zulässiger Spannungswert des Relaiselements (C_RS) ist und $V_o$ ein Spannungswert des Batteriepacks ist.

4. Batteriepack-Spannungsmessschaltung (10) aufweisend:

eine Spannungsabfallschaltung (31);
eine Relaisschaltung (11; 32); und
eine ADC-Ausgangsschaltung (12; 33),
wobei die Spannungsabfallschaltung, die Relaisschaltung (11) und die ADC-Ausgangsschaltung (12) zwischen einem Stromversorgungsspannungsanschluss (V_BP), an den eine Spannung eines Batteriepacks angelegt wird, und einem Massespannungsanschluss (GND) nacheinander in Reihe geschaltet sind, und
wobei die Relaisschaltung (11) durch Parallelschalten eines Relaiselements (C_RS) und eines Relaiswiderstands (C_RR) konfiguriert ist, **dadurch gekennzeichnet, dass**, wenn das Relaiselement (C_RS) ausgeschaltet ist, eine an beide Enden des Relaiselements (C_RS) angelegte Spannung die gleiche ist wie eine an beide Enden des Relaiswiderstands (C_RR) angelegte Spannung.

5. Schaltung nach Anspruch 4, wobei die Spannungsabfallschaltung (31) einen Widerstand (C_R1) aufweist, der zwischen dem Stromversorgungsspannungsanschluss (V_BP) und der Relaisschaltung (11; 32) geschaltet ist und zum Abnehmen einer an den Stromversorgungsspannungsanschluss (V_BP) angelegten Spannung dient.

6. Schaltung nach Anspruch 4, ferner aufweisend:
einen Widerstand (C_R2), der zwischen der Relaisschaltung (11; 32) und der ADC-Ausgangsschaltung (12; 33) geschaltet ist und zum Abnehmen und Tei-

7

len einer an die Relaisschaltung (11; 32) angelegten Spannung dient.

7. Verfahren zum Betreiben der Batteriepack-Spannungsmessschaltung (10) nach einem der Ansprüche 4 bis 6, wobei das Verfahren aufweist:

> einen Prozess des Anlegens einer Spannung des Batteriepacks zur Spannungsmessung über dem Batteriepack und des Reduzierens der Spannung durch die Spannungsabfallschaltung (31);
> einen Prozess des Bestimmens, ob sich das Relaiselement (C_RS) in einem EIN-Zustand befindet;
> einen Prozess des Einstellens einer Spannung über dem Relaiselement (C_RS), so dass sie gleich einer Spannung über dem Relaiswiderstand (C_RR) ist, wenn sich das Relaiselement (C_RS) nicht in einem EIN-Zustand befindet; und
> einen Prozess des Erfassens der Spannung des Batteriepacks.

## Revendications

1. Circuit de mesure de tension de bloc-batterie (10) comprenant :

> une première résistance (C_R1) ;
> un circuit de relais (11) ;
> une deuxième résistance (C_R2) ; et
> un circuit de sortie de convertisseur analogique-numérique (12),
> dans lequel la première résistance (C_R1), le circuit de relais (11), la deuxième résistance (C_R2) et le circuit de sortie de convertisseur analogique-numérique (12) sont connectés séquentiellement en série entre une borne de tension d'alimentation électrique (V_BP) à laquelle une tension d'un bloc-batterie est appliquée et une borne de mise à la masse (GND), et
> dans lequel le circuit de relais (11) est configuré en connectant un élément relais (C_RS) et une résistance de relais (C_RR) en parallèle,
> **caractérisé en ce que**, quand l'élément relais (C_RS) est désactivé, une tension appliquée aux deux extrémités de l'élément relais (C_RS) est la même qu'une tension appliquée aux deux extrémités de la résistance de relais (C_RR).

2. Circuit selon la revendication 1, dans lequel une valeur de résistance $R_r$ de la résistance de relais (C_RR) est déterminée pour satisfaire à l'[Équation 1] ci-après,

[Équation 1]

$$\frac{R_r}{(R_1 + R_2 + R_3)} \times V_o < V_{\lim}$$

où, $R_1$ et $R_2$ sont des valeurs de résistance des première et deuxième résistances (C_R1, C_R2), respectivement, $V_{\lim}$ est une valeur de tension admissible de l'élément relais (C_RS) et $V_o$ est une valeur de tension du bloc-batterie.

3. Circuit selon la revendication 1, dans lequel une valeur de résistance $R_r$ de la résistance de relais (C_RR) est déterminée pour satisfaire à l'[Équation 2] ci-après,

[Équation 2]

$$\frac{R_r}{(R_1 + R_2 + R_c + R_r)} \times V_o < V_{\lim}$$

où $R_1$ et $R_2$, et $R_c$ sont des valeurs de résistance des première et deuxième résistances (C_R1, C_R2) et une valeur de résistance du circuit de sortie du convertisseur analogique-numérique (12), respectivement, $V_{\lim}$ est une valeur de tension admissible de l'élément relais (C_RS) et $V_o$ est une valeur de tension du bloc-batterie.

4. Circuit de mesure de tension de bloc-batterie (10) comprenant :

> un circuit de chute de tension (31) ;
> un circuit de relais (11 ; 32) ; et
> un circuit de sortie de convertisseur analogique-numérique (12 ; 33),
> dans lequel le circuit de chute de tension, le circuit de relais (11) et le circuit de sortie du convertisseur analogique-numérique (12) sont connectés séquentiellement en série entre une borne de tension d'alimentation électrique (V_BP) à laquelle une tension d'un bloc-batterie est appliquée et une borne de mise à la masse (GND), et
> dans lequel le circuit de relais (11) est configuré en connectant un élément relais (C_RS) et une résistance de relais (C_RR) en parallèle,
> **caractérisé en ce que**, quand l'élément relais (C_RS) est désactivé, une tension appliquée aux deux extrémités de l'élément relais (C_RS) est la même qu'une tension appliquée aux deux extrémités de la résistance de relais (C_RR).

5. Circuit selon la revendication 4, dans lequel

le circuit de chute de tension (31) comprend une résistance (C_R1) connectée entre la borne de tension d'alimentation électrique (V_BP) et le circuit de relais (11 ; 32) et pour faire chuter la tension appliquée à la borne de tension d'alimentation électrique (V_BP).

6. Circuit selon la revendication 4, comprenant en outre:
une résistance (C_R2) connectée entre le circuit de relais (11 ; 32) et le circuit de sortie de convertisseur analogique-numérique (12 ; 33) et pour faire chuter et diviser une tension appliquée au circuit de relais (11 ; 32).

7. Procédé d'utilisation du circuit de mesure de tension de bloc-batterie (10) selon l'une quelconque des revendications 4 à 6, le procédé comprenant :

un processus consistant à appliquer une tension du bloc-batterie pour mesurer la tension sur le bloc-batterie et réduire ladite tension par le circuit de chute de tension (31) ;
un processus consistant à déterminer si l'élément relais (C_RS) est dans un état activé ;
un processus consistant à régler une tension sur l'élément relais (C_RS) qui soit la même qu'une tension sur la résistance de relais (C_RR) si l'élément relais (C_RS) n'est pas dans un état activé ; et
un processus consistant à détecter la tension du bloc-batterie.

**FIG. 1**

**FIG. 2**

**FIG. 3**

30

V_BP

VOLTAGE DROP
CIRCUIT — 31

RELAY CIRCUIT — 32

ADC OUTPUT
CIRCUIT — 33 → DET

GND

**FIG. 4**

**REFERENCES CITED IN THE DESCRIPTION**

**Patent documents cited in the description**

- JP 4385640 B
- KR 1211055
- KR 1211055 B1
- US 2019064285 A1